# EUROPEAN PATENT APPLICATION

(11) **EP 3 557 157 A1**
(43) Date of publication of application: **23.10.2019**
(21) Application number: 16925276.4
(22) Date of filing: 30.12.2016
(51) Int. Cl.: F24S 23/70

(54) **CONCENTRATING SOLAR APPARATUS**

(71) Applicant: Bolymedia Holdings Co. Ltd., Santa Clara, California 95051 (US)
(72) Inventor: HU, Xiaoping, Shenzhen, Guangdong 518109 (CN)
(74) Representative: Manitz Finsterwald Patent- und Rechtsanwaltspartnerschaft mbB
(86) International application number: PCT/CN2016/113411
(87) International publication number: WO 2018/119994

(57) **Abstract**

A concentrating solar apparatus, comprising two light receiving devices (110, 120). The first light receiving device (110) has a substantially horizontal first light receiving surface (111). The second light receiving device (120) has a second light receiving surface (121) that is substantially vertical with respect to the first light receiving surface (111). The first light receiving device (110) is a light energy utilization device, or is a combination of the light energy utilization device and a light guide device. The second light receiving device (120) is a Fresnel lens. Due to the relative position relationship between the second light receiving device (120) and the first light receiving device (110), sunlight is irradiated to the first light receiving surface (111) after passing through the second light receiving surface (121). By providing a substantially vertical Fresnel lens on a light path in front of the light energy utilization device, the apparatus can adapt to deflection of a relatively large angle of the sun without actively tracking the sun, and therefore has extremely high cost performance.

## Description

### Technical Field

The present disclosure relates to clean energy, and in particular to concentrating solar apparatus.

### Background of the Invention

Solar energy systems have become more extensively used with the increasing emphasis on environmental protection. Available solar energy systems can be classified into two groups: non-concentrating and concentrating.

A non-concentrating solar energy system primarily employs photovoltaic panels to collect sunlight directly. However, since it requires plentiful photovoltaic panels to gather sufficient sunlight, large areas of land are occupied, resulting in high costs and low land use efficiency.

A concentrating solar energy system generally focuses sunlight on a solar utilizing device through optical lenses so that the solar utilizing device having a smaller area can obtain sunlight concentrated by the lenses having a relative larger area; as a consequence, the system has a good ability of collecting solar energy. However, such effects usually only work when the concentrating solar energy system is used in cooperation with a sun-tracking system which typically has a complicated structure, leading to an increase in the cost of the entire system.

Therefore, it is necessary to study a concentrating solar system that can both increase solar energy collection and lower cost.

### Summary of the Invention

According to the present disclosure, a concentrating solar apparatus is provided comprising two light-receiving devices. The first light-receiving device has a first light-receiving surface that is substantially lying flat. The second light-receiving device has a second light-receiving surface that is substantially vertical with respect to the first light-receiving surface. The first light-receiving device is a solar utilizing device or a combination of a solar utilizing device and a light guiding device. The second light-receiving device is selected from a group consisting of: a transmission-typed concentrating Fresnel lens, a reflection-typed concentrating Fresnel lens, a transmission-typed astigmatic Fresnel lens, and a reflection-typed astigmatism Fresnel lens. A relative positional relationship between the second light-receiving device and the first light-receiving device is configured so as to cause sunlight to irradiate onto the first light-receiving surface after passing through the second light-receiving surface.

According to the concentrating solar apparatus of the present disclosure, by providing a substantially vertical Fresnel lens on a light path in front of the solar utilization device, the apparatus can adapt to deflection of a relatively large angle of the sun without actively tracking the sun, and therefore has extremely high cost performance. The vertical Fresnel lens used can be either concentrating or astigmatic, either transmission-type or reflection-type, and can be selected according to design needs.

The above-mentioned apparatus may further be used in combination with other concentrating devices, such as a tapered light-guiding device disposed before the solar utilizing device, a reflecting panel disposed on one or more sides of the first light-receiving surface, etc., thereby achieving a higher concentration ratio with a lower cost.

Specific examples in accordance with the present disclosure will be described in detail below with reference to the accompanying drawings. The numbers or serial numbers used herein, such as "first", "second", etc., are merely illustrative and do not have any limiting meaning.

### Brief Description of the Drawings

FIG. 1 is a schematic view of a concentrating solar apparatus of a first embodiment;
FIG. 2 is a schematic view of a concentrating solar apparatus of a second embodiment;
FIG. 3 is a schematic view of a concentrating solar apparatus of a third embodiment;
FIG. 4 is a schematic view of a concentrating solar apparatus of a fourth embodiment.

### Detailed Description

### First Embodiment

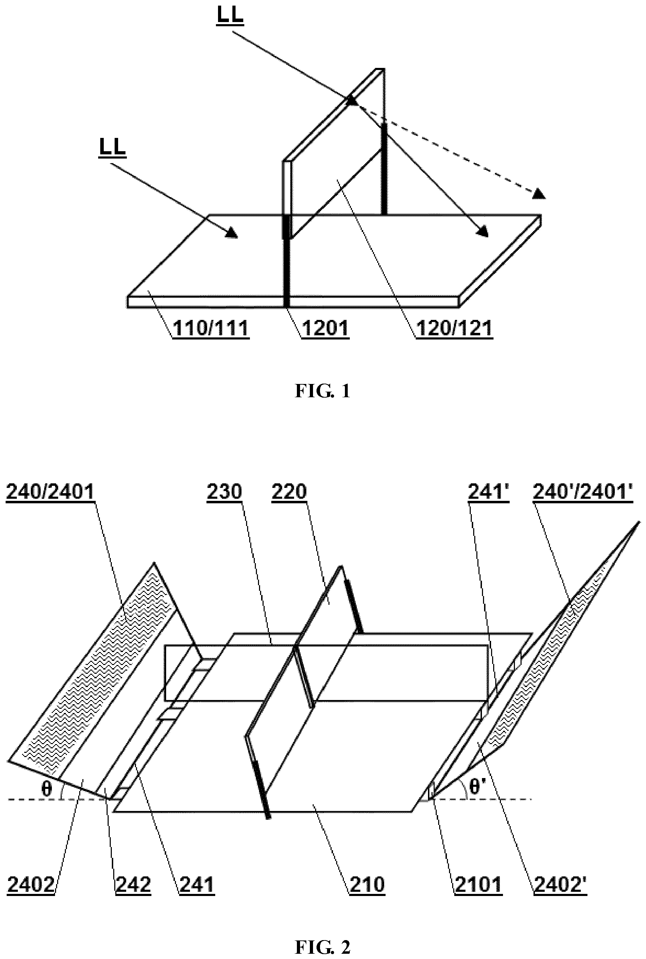

Referring to FIG. 1, a concentrating solar apparatus according to an embodiment of the present disclosure may include a first light-receiving element 110 and a second light-receiving element 120.

The first light-receiving element 110 has a first light-receiving surface 111 that is substantially lying flat.

The second light-receiving element 120 has a second light-receiving surface 121 that is arranged substantially vertical with respect to the first light-receiving surface.

The terms "lying flat" and "vertical" as used herein are relative definitions. When two light-receiving surfaces are arranged in a staggered manner, and the angle between the normals of the two surfaces is ranged in 60 and 120 degrees, one light-receiving surface may be regarded as "substantially lying flat" and the other peer "substantially vertical".

The first light-receiving element 110 may be either a solar utilizing device or a combination of a solar utilizing device with a light guiding device, such as a solar utilizing device with a light concentrating device. The solar utilizing device generally refers to various devices that can convert solar energy into other energy, such as a photovoltaic panel, a solar-thermal conversion device and the like. The photovoltaic panel as mentioned herein generally refers to all kinds of solar photoelectric conversion device that can directly covert solar energy into electrical energy, such as silicon-based photovoltaic panels, composite semiconductor (e.g. gallium arsenide, copper indium gallium selenide, cadmium telluride, calcium-titanium semiconductor) photovoltaic panels, photovoltaic thin films, quantum dot photovoltaic panels and the like. The solar utilizing device can be used alone or in cascade with other energy utilizing devices, such as cascading photovoltaic panels with thermal energy utilizing devices (e.g. heaters or coolers) to achieve higher solar energy utilization efficiency.

Therefore the first light-receiving element in the present disclosure can be selected and designed according to the needs of practical applications. When the first light-receiving element only includes the solar utilizing device, the surface of the solar utilizing device is the first light-receiving surface, and when a light-guiding device is further provided on the optical path in front of the solar utilizing device, the light-receiving surface of the light-guiding device is the first light-receiving surface. Only the first light-receiving surface of the first light-receiving device is shown in FIG. 1 for the sake of simplicity, and other components and arrangements that may exist are omitted.

The second light-receiving element 120 is a Fresnel lens selected from a group consisting of: a transmission-typed concentrating Fresnel lens, reflection-typed concentrating Fresnel lens, transmission-typed astigmatic Fresnel lens, and reflection-typed astigmatic Fresnel lens.

The Fresnel lens has the advantages of being thin and easy-to-batch production. For a detailed introduction of Fresnel lens, please refer to a PCT application No. WO/2016/082097 titled "Fresnel Lens System", published on June 2, 2016, which is not repeated herein. As used herein, a "concentrating" (or "astigmatic") Fresnel lens refers to a Fresnel lens having a tooth surface originated from a convex lens face (or a concave lens face); in this manner, the Fresnel lens thus has a converging (or diverging) effect on light. The Fresnel lens can be transmissive or reflective. A reflective lens is formed by providing a reflective layer or a reflective coating on one side (or between two surfaces) of a transmission-typed lens. All respective Fresnel lenses referred to herein may be either a single-sided Fresnel lens having a smooth surface on one side and a tooth surface on another side, or a double-sided Fresnel lens having a tooth surface on both sides. Each tooth surface of each Fresnel lens may be either a simple lens face containing only one Fresnel unit or a composite lens face composed of a plurality of Fresnel units.

Referring to FIG. 1, the sunlight LL sometimes fails to reach the first light-receiving surface due to the incident angle, as indicated by the dotted arrow in FIG. 1. Further, even if the sunlight directly reaches the first light-receiving surface, when the first light-receiving surface is the surface of the solar utilizing device, the utilization efficiency of the device is relatively low since the incident angle is relatively large. By providing a vertical Fresnel lens, it is possible to illuminate the sunlight onto the first light-receiving surface via the second light-receiving surface by refraction (or refraction and reflection), resulting in concentrating the incident light and improving the incident angle.

It is worth mentioning that not only the concentrating Fresnel lens often used for concentrating can refract sunlight to the first light-receiving surface, but also the astigmatic Fresnel lens having a diverging effect on light can also diverge light from the top portion of the first light-receiving surface to the first light-receiving surface by astigmatism. Moreover, the vertical Fresnel lens can capture a larger range of sunlight due to its characteristics of diverging light.

Preferably, the astigmatic Fresnel lens may employ a linear astigmatic Fresnel lens. The so-called "linear" lens, including a linear astigmatic lens and a linear concentrating lens, generally means that the focus center of the lens is a line. An advantageous aspect of applying "linear" astigmatism in the present disclosure is that the light is diverged only in one direction. For example, the direction of the linear astigmatism of the second light-receiving device can be the same as a direction the normal plane of the first light-receiving surface oriented toward the first light-receiving surface. In an example, the linear astigmatic lens can be served as a Fresnel lens having a tooth surface originated from a concave cylindrical surface, a concave elliptical cylinder surface, or a concave polynomial cylinder surface.

In addition to the transmission-type lens shown in FIG. 1, as another preferred embodiment, the second light-receiving device may also employ a double-sided reflection-typed astigmatic Fresnel lens. Such lens includes two Fresnel lens faces disposed back to back, and one double-sided reflecting surface is arranged between the two Fresnel lens faces such that light on both sides of the lens can be reflected and concentrated.

The second light-receiving device may be erected at any position on the first light-receiving surface. Preferably, the second light-receiving device can be at least partially located in a central region of the first light-receiving surface, for example on a symmetric dividing line of the first light-receiving surface. In this embodiment, the second light-receiving device 120 is supported by a support member 1201 above the first light-receiving surface or a mounting mechanism thereof, and has a gap between the lower end of the second light-receiving device and the first light-receiving surface. The gap can reduce the material cost on one hand and unnecessary light energy loss on the other. For example, the light energy can be absorbed and reflected by the lower portion of the second light-receiving device. In other embodiments, the second light-receiving device may also be arranged below the first light-receiving surface according to the needs of the optical path design. In still other embodiments, in order to stable the installment of the second light-receiving device, the second light-receiving device may be arranged to be crossed over the first light-receiving surface so that the second light-receiving surface and the first light-receiving surface may be crisscrossed.

In other embodiments, a third light-receiving device may be further provided having a third light-receiving surface that is substantially vertical with respect to the first light-receiving surface. The third light-receiving device, which may employ various Fresnel lenses described above, may have characteristics similar to those of the second light-receiving device, and will not be described again. The third light-receiving surface and the second light-receiving surface may be arranged on the same side or different sides of the first light-receiving surface. The third light-receiving surface may be substantially perpendicular to the second light-receiving surface, or may be substantially parallel to the second light-receiving surface.

The device of this embodiment can be further used in conjunction with other concentrating devices to form a larger or more complex concentrating solar system so as to achieve a higher concentrating ratio.

### Second Embodiment

Referring to FIG. 2, a concentrating solar apparatus according to another embodiment of the present disclosure may include a first light-receiving element 210, a second light-receiving element 220, a third light-receiving element 230 and two side reflecting panels 240, 240'.

The first light-receiving element 210 having a first light-receiving surface as its working surface is a photovoltaic panel that is substantially lying flat.

The second light-receiving element 220 is a double-sided reflection-typed linear astigmatic Fresnel lens that is arranged substantially vertically on the photovoltaic panel.

The third light-receiving element 230 is a transmission-typed linear astigmatic Fresnel lens arranged on the same side of the photovoltaic panel as the second light-receiving element and also disposed substantially vertically on the photovoltaic panel. The third light-receiving element is substantially perpendicular to the second light-receiving device, thereby the second and third light-receiving devices are in a crisscross shape.

The side reflecting panels 240, 240' are each arranged on opposite sides of the first light-receiving surface by respective rotating shafts 241, 241', specifically, pivotally fixed to opposite edges of a support mechanism 2101. The side reflecting panels in the present disclosure can be served as a variety of devices having light reflecting ability, such as a mirror reflector or a reflective lens. One side reflecting panel can be formed from a single device or be a hybrid panel formed by different types of devices. Preferably, at least a portion of the surface of the side reflecting panel is formed by one or more of the following: a mirror reflector, and a reflection-typed astigmatic Fresnel lens.

By the rotation of the rotating shaft, the angles θ, θ' of respective side reflecting panels with respect to the first light-receiving surface can be adjusted such that the sunlight reaching the reflecting panel is at least partially guided to the region at which the first light-receiving surface is located. The second light-receiving device diffuse the light from the side reflecting panels downward and reflects it so as to collect the light onto the first light-receiving surface. The third light-receiving device serves for collecting sunlight coming from another direction so that the apparatus can adapt to the deflection of the sun in different directions. For example, the second light-receiving device 220 (and the reflecting panels 240, 240') can be adapted to the change of the angle of the sun along a direction from eastward to westward during a day, and the third light-receiving device 230 can be used to adapt to the deflection of the illumination angle caused by the seasonal variation of the sun.

Preferably, the angles θ, θ' of respective reflecting panels 240, 240' with respect to the first light-receiving surface can be adjusted between 45 and 75 degrees to obtain a better concentrating ratio. Such inclined angle can be adjusted manually; however, in other embodiments, it can be automatically adjusted by a provided drive mechanism.

As a preferred embodiment, in this embodiment, the side reflecting panels 240, 240' are hybrid panels, in which the upper part is formed by reflection-typed astigmatic Fresnel lenses 2401, 2401', and the lower part is formed by mirror reflectors 2402, 2402'. By using the reflection-typed astigmatic Fresnel lens, the area of the side reflecting panels and the inclined angles θ, θ' can be effectively increased so that the side reflecting panels can receive more sunlight, thereby increasing the concentration ratio of the entire apparatus. Since the cost of the reflective lens is higher than that of the conventional mirror, it is possible to use a reflective lens only on the upper portions of the side reflecting panels to obtain a best cost performance. Preferably, there is a gap 242 between the lower end of the at least one side reflecting panel and its axis of rotation to facilitate cleaning dust and debris.

Since the mirror has good thermal conductivity, preferably, the side reflecting panels can also be thermally connected to the photovoltaic panel to assist in heat dissipation. Further preferably, the at least one side reflecting panel has a metal layer (such metal layer may be the mirror itself or an additional layer) which may be used as a reflective surface of the side reflecting panel or on the back side of the side reflecting panel. The photovoltaic panel can be thermally connected to the side reflecting panels or the metal layer by a support mechanism made of for example a metallic material.

### Third Embodiment

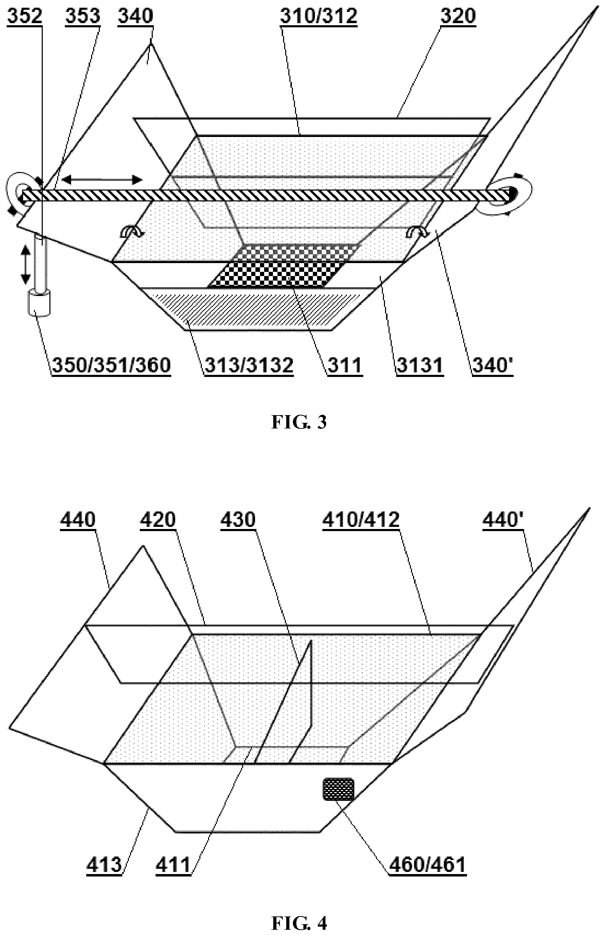

Referring to FIG. 3, a concentrating solar apparatus according to still another embodiment of the present disclosure may include a first light-receiving element 310, a second light-receiving element 320 and two side reflecting panels 340, 340'.

The first light-receiving element 310 may include a photovoltaic panel 311 and its light guiding device. The light guiding device may specifically include a transmission-typed concentrating Fresnel lens 312 and a tapered light guiding device 313.

The Fresnel lens 312 is formed as a first light-receiving surface that is integrated with a support mechanism.

The tapered light guiding device 313 is arranged between the Fresnel lens 312 and the photovoltaic panel 311, wherein the larger end of the tapered light guiding device faces toward the Fresnel lens 312, and the smaller end toward the photovoltaic panel 311. At least part of the inner wall of the tapered device is a reflective surface for further condensing light so as to increase the concentration ratio. In this embodiment, the Fresnel lens 312 and the tapered light guiding device 313 are formed as a closed quadrangular hollow cone, and the photovoltaic panel 311 is arranged at the bottom of the tapered light guiding device 313. In other embodiments, the cross-sectional shape of the tapered light guiding device may also be hexagonal, circular or elliptical. In other embodiments, the tapered light guiding device can also be omitted, and the solar utilizing device can be directly disposed under the transmission-typed concentrating Fresnel lens. In other embodiments, a reflection-typed concentrating Fresnel lens can also be employed, and the solar utilizing device can be arranged over it.

The supporting wall of the tapered light guiding device may be comprised of one or more devices selected from a group consisting of: a mirror reflector, a reflection-typed astigmatic Fresnel lens, a transparent wall or a hollowed-out opening. In this embodiment, the supporting wall of the tapered light guiding device 313 is composed of a mirror reflector and a transparent wall (or a hollowed-out opening), wherein the portion thereof close to the Fresnel lens 312 is a transparent wall 3131, and the portion thereof close to the photovoltaic panel is a mirror reflector 3132. For the sake of simplicity, as shown in FIG. 3, such hybrid arrangement is illustrated on only one side wall, with the remaining side walls remaining as an integral whole. The mirror reflector can be served as a mirror having a reflective surface coated with a transparently protective layer (such as glass or acrylic), or the mirror reflector is formed by plating a reflective film directly onto a smooth surface. In other embodiments, the supporting walls of the tapered light guiding device may all be formed by a mirror reflector or a reflection-typed astigmatic Fresnel lens (including a reflection-typed linear astigmatic Fresnel lens).

The second light-receiving device 320 is a transmission-typed linear astigmatic Fresnel lens which forms a crisscross structure with the Fresnel lens 312, so that a portion of the second device is arranged above the first light-receiving surface and another portion below the first light-receiving surface.

The side reflecting panels 340, 340' are respectively arranged on opposite sides of the Fresnel lens 312 through respective rotating shafts; and in this embodiment a mirror reflector acts as each side reflecting panel.

As a preferred embodiment, a first driving mechanism 350 is further included in this embodiment for driving the side reflecting panels to rotate according to the needs of the sun tracking so as to adjust the angles of the panels with respect to the first light-receiving surface. The first driving mechanism in this embodiment may specifically include a motor 351, a threaded rod352 that telescopically moves under the driving of the motor, and a linkage rod 353. The free end of the threaded rod is connected to the reflecting panel 340 to push it up and down, and the linkage rod 353 may drive the reflecting panel 340' to be deflected synchronously.

Further preferably, a vibrator 360 is further provided in this embodiment. The vibrator usually includes a vibrating element for mechanical vibration and a driving circuit thereof. Mechanically connecting the vibrating element to at least one of the light-receiving surfaces of the apparatus can cause it to vibrate, thereby shaking off dust or foreign matter on the light-receiving surface. As a preferred embodiment, the driving circuit of the vibrator includes at least one inductance element and at least one capacitance element which are connected in series, so that the circuit resonance frequency ωc of the driving circuit can be set to match (including be the same as or be close to) the mechanical resonance frequency com of the vibrating element. When the frequency of a drive signal (alternating current or voltage) inputted to the driving circuit is ωc, the vibrator can operate in a "double resonance" state in which mechanical resonance and electrical resonance may occur simultaneously. In the double resonance state, the power consumption of the driving circuit may be significantly reduced. The vibrator may be a piezoelectric vibrator, and the vibrating element may employ a piezoelectric element (for example, a piezoelectric vibrating piece) which is connected in series in the driving circuit and simultaneously functions as the capacitance element in the driving circuit; alternatively, the vibrator may be an electromagnetic vibrator, and the vibrating element may adopt a sheet-shaped magnetized material which is not part of the driving circuit, and the driving circuit excites the sheet-like magnetized material to generate vibration through the inductance element.

The motor 351 of the first driving mechanism in this embodiment may employ an ultrasonic motor, which can be regarded as a piezoelectric vibrator operating at an ultrasonic frequency, and the oscillator of the ultrasonic motor may function as the vibrating element, thereby realizing automatic cleaning for the apparatus.

### Fourth Embodiment

Referring to FIG. 4, a concentrating solar apparatus according to further still another embodiment of the present disclosure may include a first light-receiving element 410, a second light-receiving element 420, a third light-receiving element 430, two side reflecting panels 440, 440' and a vibrator 460.

The first light-receiving element 410 may include a photovoltaic panel 411 and its light guiding device. The light guiding device may specifically include a transmission-typed concentrating Fresnel lens 412 and a tapered light guiding device 413. The Fresnel lens 412 is formed as a first light-receiving surface that is integrated with a support mechanism. The inner wall of the tapered light guiding device 413 is a reflective mirror. The Fresnel lens 412 and the tapered light guiding device 413 are formed as a closed quadrangular hollow cone, and the photovoltaic panel 411 is arranged at the bottom of the tapered light guiding device 413.

The second light-receiving element 420 and the third light-receiving element 430 are both transmission-typed linear astigmatic Fresnel lenses which are perpendicular to each other and arranged at either side of the Fresnel lens 412 respectively, wherein the third light-receiving element 430 is arranged within the tapered light guiding device 413.

The side reflecting panels 440, 440' are respectively fixed onto two opposite edges of the Fresnel lens 412.

The vibrating element 461 of the vibrator 460 is fixedly arranged on the supporting wall of the tapered light guiding device 413. The vibrator 460 may be a piezoelectric vibrator with an ultrasonic frequency as its vibrational frequency. The vibrator may be operated in a "double resonance" mode (in which the mechanical resonance frequency is identical to the circuital resonance frequency) and worked in a timed or controlled manner to realize self-cleaning for the apparatus.

The principle and implementation manners present disclosure have been described above with reference to specific embodiments, which are merely provided for the purpose of understanding the present disclosure and are not intended to limit the present disclosure. It will be possible for those skilled in the art to make variations based on the principle of the present disclosure.

## Claims

1. A concentrating solar apparatus, comprising:
a first light-receiving element having a first light-receiving surface that is substantially lying flat, and
a second light-receiving element having a second light-receiving surface that is arranged substantially vertical with respect to the first light-receiving surface,
wherein the first light-receiving element is a solar utilizing device or a combination of a solar utilizing device and a light guiding device, and
the second light-receiving element is selected from a group consisting of a transmission-typed concentrating Fresnel lens, a reflection-typed concentrating Fresnel lens, a transmission-typed astigmatic Fresnel lens, and a reflection-typed astigmatic Fresnel lens; and a relative position relationship between the second light-receiving element and the first light-receiving element is configured so that sunlight irradiate onto the first light-receiving surface after passing through the second light-receiving surface.

2. The apparatus of claim 1, wherein the apparatus has at least one of the following features:
the second light-receiving element being at least partially arranged in a central region of the first light-receiving surface;
the second light-receiving element being arranged above or below the first light-receiving surface, and a gap being provided between the lower end of the second light-receiving element and the first light-receiving surface; and
the second light-receiving surface and the first light-receiving surface being arranged in a crisscross shape.

3. The apparatus of claim 1 or 2, wherein
the first light-receiving element comprises
a concentrating Fresnel lens which forms the first light-receiving surface; and
a solar utilizing device which is arranged below the concentrating Fresnel lens where the solar utilizing device is transmission-typed, or arranged above the concentrating Fresnel lens where the solar utilizing device is reflection-typed.

4. The apparatus of claim 3, wherein
the first light-receiving element further comprises
a tapered light guiding device arranged between the concentrating Fresnel lens and the solar utilizing device, wherein the larger end of the tapered light guiding device faces toward the Fresnel lens, the smaller end of the tapered light guiding device faces toward the solar utilizing device, and at least part of the inner wall of the tapered light guiding device is a reflective surface.

5. The apparatus of claim 4, wherein
the supporting wall of the light guiding device is comprised of one or more devices selected from a group consisting of: a mirror reflector, a reflection-typed astigmatic Fresnel lens, a transparent wall or a hollowed-out opening.

6. The apparatus of any one of claims 1 to 5, further comprising:
a third light-receiving device having a third light-receiving surface that is substantially vertical with respect to the first light-receiving surface; the third light-receiving device being selected from a group consisting of: a transmission-typed concentrating Fresnel lens, a reflection-typed concentrating Fresnel lens, a transmission-typed astigmatic Fresnel lens, and a reflection-typed astigmatic Fresnel lens;
wherein
the third light-receiving surface and the second light-receiving surface are both arranged on the same side of the first light-receiving surface, and the third light-receiving surface is substantially perpendicular to the second light-receiving surface; or
the third light-receiving surface and the second light-receiving surface are respectively arranged on different sides of the first light-receiving surface, and the third light-receiving surface is substantially perpendicular to or substantially parallel to the second light-receiving surface.

7. The apparatus of any one of claims 1 to 6, wherein the apparatus has at least one of the following features:
the reflection-typed astigmatic Fresnel lens being specifically a double-sided reflection-typed astigmatic Fresnel lens which includes two Fresnel lens faces arranged back to back and one double-sided reflecting surface arranged between the two Fresnel lens faces; and
the transmission-typed or reflection-typed astigmatic Fresnel lens being specifically a transmission-typed or reflection-typed linear astigmatic Fresnel lens.

8. The apparatus of any one of claims 1 to 7, further comprising:
at least one side reflecting panel arranged on a side of the first light-receiving surface such that the sunlight reaching the side reflecting panel is at least partially guided to a region where the first light-receiving surface or the second light-receiving surface is located.

9. The apparatus of claim 8,
wherein at least part of the surface of the side reflecting panel is formed by one or more devices selected from a group consisting of: a mirror reflector, and a reflection-typed astigmatic Fresnel lens.

10. The apparatus of claim 9, wherein
the at least part of the surface of the side reflecting panel is formed by a reflection-typed liner astigmatic Fresnel lens; or
the upper portion of the side reflecting panel is formed by a reflection-typed liner astigmatic Fresnel lens, and the lower portion of the side reflecting panel is formed by a mirror reflector.

11. The apparatus of any one of claims 8 to 10, wherein
the at least one side reflecting panel is provided with a metal layer served as a reflective surface or disposed on the back side of the side reflecting panel; and
the solar utilizing device is a photovoltaic panel thermally connected with the metal layer.

12. The apparatus of any one of claims 8 to 11, wherein the apparatus has at least one of the following features:
the angle of the side reflecting panel with respect to the first light-receiving surface being at least able to be adjusted between 45 and 75 degrees; and
the lower end of the at least one side reflecting panel being separated from the first light-receiving surface by a gap.

13. The apparatus of claim 12,
further comprising a first driving mechanism configured for driving the side reflecting surface to rotate according to the needs of sun tracking so as to adjust the angle of the panel with respect to the first light-receiving surface.

14. The apparatus of any one of claims 1 to 13,
further comprising a vibrator having a vibrating element and a driving circuit thereof,
the vibrating element being mechanically connected with at least one light-receiving surface of the apparatus so as to drive it to vibrate, and
the vibrator being selected from a piezoelectric vibrator and an electromagnetic vibrator.

15. The apparatus of claim 14, wherein
the driving circuit comprises at least one inductance element and at least one capacitance element which are connected in series, the circuit resonance frequency of the driving circuit being matched with the mechanical resonance frequency of the vibrating element;
the vibrating element is a piezoelectric element acting as the capacitance element of the driving circuit where the vibrator is a piezoelectric one; and
the vibrating element is made of a sheet-shaped magnetized material where the vibrator is an electromagnetic one, and the driving circuit excites the vibrating element to generate vibration through the inductance element.

16. The apparatus of claim 14 as dependent on claim 13, wherein
the vibrator is an ultrasonic motor, and the oscillator of the ultrasonic motor functions as the vibrating element, and
the ultrasonic motor further serves as a motor of the first driving mechanism.
